# EUROPÄISCHE PATENTANMELDUNG

(11) **EP 3 489 373 A1**
(43) Veröffentlichungstag der Anmeldung: **29.05.2019**
(21) Anmeldenummer: 17204083.4
(22) Anmeldetag: 28.11.2017
(51) Int. Cl.: C22C 1/04, C22C 27/02, H01L 39/24

(54) **VERFAHREN ZUR SCHMELZMETALLURGISCHEN DARSTELLUNG DER INTERMETALLISCHEN VERBINDUNG NB3SN**

(71) Anmelder: Heraeus Deutschland GmbH & Co. KG, 63450 Hanau (DE)
(72) Erfinder: Spaniol, Bernd, 63546 Hammersbach (DE); Csirak, Stefan, 63526 Erlensee (DE); Virgin, Markus, 63856 Bessenbach (DE); Schultheis, Markus, 36103 Flieden (DE)
(74) Vertreter: Heraeus IP

(57) **Zusammenfassung**

Die Erfindung betrifft ein Verfahren zur schmelzmetallurgischen Darstellung der intermetallischen Verbindung Nb₃Sn. Das Verfahren umfasst als Schritte ein Pressen von Nb-Partikeln und Sn-Partikeln zu einer Startelektrode, wobei die gepresste Startelektrode in einem Lichtbogen unter Vakuum umgeschmolzen wird, wobei ein erster Formkörper erhalten wird. Alternativ umfasst das Verfahren als Schritte ein Umschmelzen einer Nb-Startelektrode in einem Lichtbogen unter Vakuum, wobei während des Umschmelzens Sn-Partikel in die sich bildende Nb-Schmelze eingebracht werden, wobei ein erster Formkörper erhalten wird. Das Stoffmengenverhältnis von Nb zu Sn wird so gewählt, dass der erhaltene erste Formkörper wenigstens 50 Gew.-% der intermetallischen Verbindung Nb₃Sn als A15 Phase sowie gegebenenfalls freies Nb und/oder Sn und unvermeidbare Verunreinigungen enthält.

## Beschreibung

Die Erfindung betrifft ein Verfahren zur schmelzmetallurgischen Darstellung der intermetallischen Verbindung Nb₃Sn. Die Erfindung betrifft ferner eine intermetallische Verbindung herstellbar durch ein solches Verfahren.

Nb₃Sn ist eine intermetallische Verbindung aus der Gruppe der Niobzinn-Verbindungen. Neben Nb₃Sn sind vor allem die Phasen Nb₆Sn₅ und NbSn₂ bekannt. Nb₃Sn kristallisiert in der sogenannten A15 Phase und ist als Typ II Supraleiter mit einer Sprungtemperatur von 18,3 K bekannt. Aufgrund dieser Sprungtemperatur hat Nb₃Sn deutlich bessere elektrische Eigenschaften als Niob-Titan, ist jedoch auch ein extrem spröder Werkstoff der nicht unmittelbar zu Drähten für supraleitende Spulen verarbeitet werden kann. Zur praktischen Verwendung der Verbindung in supraleitenden Drähten und Kabeln wird daher üblicherweise von duktilen Vorläufern ausgegangen.

Als Beispiel sei das Bronze Verfahren genannt, bei dem von einer zylinderförmigen Formkörper aus Bronze ausgegangen wird. Die Bronze ist von Bohrungen durchzogen, in die Stäbe aus speziell dotiertem Niob eingeführt werden. Die äußere Oberfläche des Bronzestabes ist dünn mit Tantal beschichtet und zur Verbesserung der Zieheigenschaften mit einer Kupfermatrix ummantelt. Der aus diesem Stab gezogene Draht kann nun in beliebige Formen gewickelt werden, ist jedoch nicht supraleitend. Diese Eigenschaft erhält er erst durch Erhitzen auf eine Temperatur von ca. 700 °C. Dabei diffundiert Zinn aus der Bronze in die Niobdrähte. Die Glühung wird abgebrochen, wenn in den Drähten die Zusammensetzung Nb₃Sn erreicht ist. Die Tantal-Barriere verhindert während des Glühvorgangs, dass Zinn nach außen in den Kupfermantel diffundiert. Nach dieser Behandlung sind die Drähte supraleitend, aber auch mechanisch sehr empfindlich, d.h. das eigentliche, supraleitende Nb₃Sn kann bei geringer Biegung der Drähte brechen.

Bei der Herstellung von Hohlraumresonatoren für Teilchenbeschleuniger mit hoher Endenergie kommen vorteilhafterweise ebenfalls supraleitende Materialien wie Nb₃Sn zum Einsatz. Dabei ist die Formgebung des Hohlraumresonators entscheidend, weswegen sich computergesteuerte additive Verfahren zur Herstellung solcher Bauteile anbieten. Dafür werden die entsprechenden supraleitenden Verbindungen in großer Menge und hoher Reinheit benötigt, um entsprechende Partikel zur Verarbeitung in additiven Verfahren zu generieren. Insbesondere kann zur Herstellung der Hohlraumresonatoren hochreines Nb₃Sn in A15 Phase zum Einsatz kommen.

Nb₃Sn kann durch Reaktion der Elemente bei 900 bis 1000 °C oder NbSn₂ mit Niob und einem geringen Anteil Cu als Katalysator bei 600 °C gewonnen werden. Alternativ kann auch Niob(V)-chlorid und Zinn(II)-chlorid bei Temperaturen unter 1000 °C zu Nb₃Sn umgesetzt werden, wobei als Nebenprodukt gasförmiger Chlorwasserstoff erhalten wird.

Die EP 0 109 233 offenbart ein Verfahren zur Darstellung von Nb₃Sn in dem ein Niobhalogen-Dampf mit flüssigem Zinn umgesetzt wird, wobei das Niobhalogen unterhalb seiner Dissoziationstemperatur verwendet wird und sich das Produkt (Nb₃Sn) als Präzipitat im Reaktionsgemisch absetzt.

Die vorgenannten Verfahren weisen in der Regel den Nachteil auf, dass die Entstehung von Nb₃Sn, das heißt Niobzinn als A15 Phase, schwierig zu kontrollieren ist. In der Regel werden als Nebenprodukte andere Niobzinn-Phasen in nicht insignifikanten Mengen erhalten, die anschließend nur schwierig von der Hauptphase abzutrennen sind. Da die Umsetzung oft nicht vollständig ist muss häufig mit großen Sn Überschüssen gearbeitet werden, was wiederum Schwierigkeiten bei der anschließenden Aufreinigung mit sich bringt.

Eine Aufgabe der vorliegenden Erfindung besteht allgemein darin, die Nachteile des Standes der Technik wenigstens teilweise zu überwinden.

Eine weitere Aufgabe der vorliegenden Erfindung besteht darin ein Verfahren bereitzustellen, welches die Darstellung der intermetallischen Verbindung Nb₃Sn in hoher Reinheit und in großen Mengen, insbesondere im kg-Maßstab, ermöglicht.

Eine weitere Aufgabe der vorliegenden Erfindung besteht darin ein Verfahren zur Darstellung der intermetallischen Verbindung Nb₃Sn bereitzustellen, über welches die Ausbeute an Nb₃Sn durch die eingesetzte Menge Nb und Sn gesteuert werden kann, und in dem als Nebenprodukte bei Verwendung eines Nb- oder Sn-Überschusses im Wesentlichen reines Nb oder reines Sn als Begleitprodukte anfallen.

Eine weitere Aufgabe der vorliegenden Erfindung besteht darin ein Verfahren zur Darstellung der intermetallischen Verbindung Nb₃Sn bereitzustellen, das als Produkt im Wesentlichen Nb₃Sn in der A15 Phase generiert, wobei andere Niobzinn Phasen nur in insignifikanten oder nicht störenden Mengen entstehen.

Ein Beitrag zur Lösung wenigstens einer der vorgenannten Aufgaben wird durch die Gegenstände der unabhängigen Ansprüche bereitgestellt. Die abhängigen Ansprüche stellen bevorzugte Ausführungsformen der vorliegenden Erfindung dar, die ebenfalls einen Beitrag zur Lösung mindestens einer der vorgenannten Aufgaben leisten. Merkmale und Details, die in Zusammenhang mit dem erfindungsgemäßen Verfahren beschrieben werden, gelten dabei auch in Zusammenhang mit der erfindungsgemäßen Niob-Zinn Verbindung und umgekehrt.

Einen Beitrag zur Lösung wenigstens einer der vorgenannten Aufgaben wird bereitgestellt durch ein Verfahren zur schmelzmetallurgischen Darstellung der intermetallischen Verbindung Nb₃Sn, wobei das Verfahren die folgenden Schritte umfasst:
i. Pressen von Nb-Partikeln und Sn-Partikeln zu einer Startelektrode, wobei die gepresste Startelektrode in einem Lichtbogen unter Vakuum umgeschmolzen wird, wobei ein erster Formkörper erhalten wird oder
ii. Umschmelzen einer Nb-Startelektrode in einem Lichtbogen unter Vakuum, wobei während des Umschmelzens Sn-Partikel in die sich bildende Nb-Schmelze eingebracht werden, wobei ein erster Formkörper erhalten wird,
wobei das Stoffmengenverhältnis von Nb zu Sn so gewählt ist, dass der erhaltene erste Formkörper wenigstens 50 Gew.-% der intermetallischen Verbindung Nb₃Sn als A15 Phase sowie gegebenenfalls freies Nb und/oder Sn und unvermeidbare Verunreinigungen enthält.

Bevorzugt ergänzen sich die eingesetzten Gewichtsanteile von Sn und Nb zu 100 Gew.-%, das heißt weitere Metalle oder sonstige Element werden im erfindungsgemäßen Verfahren nicht eingesetzt.

Gemäß der ersten Alternative des erfindungsgemäßen Verfahrens werden Nb- und Sn-Partikel in einem vordefinierten stöchiometrischen Verhältnis zu einer Startelektrode gepresst. Die gepresste Startelektrode wird mit Hilfe eines Vakuum-Lichtbogen-Umschmelzverfahrens *(vacuum arc remelting - VAR)* umgeschmolzen, wobei ein erster Formkörper erhalten wird.

Gemäß der zweiten Alternative des erfindungsgemäßen Verfahrens wird eine reine Niob-Startelektrode mit Hilfe eines Vakuum-Lichtbogen-Umschmelzverfahrens umgeschmolzen. Während des Umschmelzens wird der sich bildenden Nb-Schmelze Zinn in einer definierten Menge zugegeben, wobei ein erster Formkörper erhalten wird. Als Nb Startelektrode kommt entweder ein erschmolzener zylindrischer Nb-Bolzen oder eine aus Nb-Spänen gepresste Elektrode zum Einsatz.

Für beide Alternativen wird das Stoffmengenverhältnis von Nb zu Sn (oder *vice versa*) so gewählt, dass der erhaltene Formkörper wenigstens 50 Gew.-% der intermetallischen Verbindung Nb₃Sn als A15 Phase enthält. Bevorzugt wird das Stoffmengenverhältnis von Nb zu Sn so gewählt, dass der erhaltene Formkörper wenigstens 75 Gew.-%, weiter bevorzugt wenigstens 90 Gew.-%, weiter bevorzugt wenigstens 95 Gew.-%, weiter bevorzugt wenigstens 99 Gew.-%, und weiter bevorzugt wenigstens 99,5 Gew.-% der intermetallischen Verbindung Nb₃Sn als A15 Phase enthält.

Wird Nb oder Sn im Überschuss verwendet, wird durch das erfindungsgemäße Verfahren im wesentlichen Nb₃Sn als Hauptprodukt sowie freies Nb oder Sn als Begleitprodukte neben unvermeidbaren Verunreinigungen erhalten.

Unvermeidbare Verunreinigungen sind insbesondere durch die Rohstoffe eingetragene Begleitelemente. Solche Verunreinigungen sind in der Regel in Mengen kleiner als 0,1 Gew.-% im unmittelbaren Verfahrens-Produkt enthalten, bevorzugt in Mengen kleiner 1000 mg/kg, weiter bevorzugt in Mengen kleiner 100 mg/kg, jeweils bezogen auf die Gesamtmenge der Verunreinigung im unmittelbaren Verfahrensprodukt.

Unvermeidbare Verunreinigungen sind ferner Niobzinn-Verbindungen die nicht in der A15 Phase, das heißt als Nb₃Sn, vorliegen. Insbesondere handelt es sich dabei um Nb₆Sn₅ sowie um NbSn₂. Diese Produkte oder intermetallische Verbindungen werden auch als unerwünschte Nebenprodukte bezeichnet. Bevorzugt ist jede dieser Verbindungen individuell für sich in einer Menge kleiner 5 Gew.-% im Verfahrens-Produkt enthalten, weiter bevorzugt in einer Menge kleiner als 1 Gew-%, und weiter bevorzugt in einer Menge kleiner als 0,1 Gew.-%.

Es wurde überraschend gefunden dass sich das erfindungsgemäße schmelzmetallurgische Verfahren nicht nur zur Herstellung von Nb₃Sn im Kilogramm-Maßstab eignet, sondern dass vornehmlich Nb₃Sn in der A15 Phase gebildet wird und nur geringe Konzentrationen an nicht erwünschten Niobzinn-Verbindungen im unmittelbaren Verfahrens-Produkt enthalten sind.

Gemäß einer bevorzugten Ausführungsform der Erfindung umfasst das erfindungsgemäße Verfahren zusätzlich die folgenden Schritte:
a. Mechanisches Zerkleinern des ersten Formkörpers zu Partikeln,
b. Mischen der in Schritt a. erhaltenen Partikeln mit Nb- und/oder Sn-Partikeln und Pressen der Mischung zu einem zweiten Formkörper, wobei der Anteil der in Schritt a. erhaltenen Partikel im zweiten Formkörper bei höchstens 80 Gew.-% liegt,
c. Umschmelzen des zweiten Formkörpers in einem Lichtbogen unter Vakuum, wobei ein dritter Formkörper erhalten wird,
wobei das Stoffmengenverhältnis von Nb zu Sn so gewählt ist, dass der erhaltene dritte Formkörper wenigstens 70 Gew.-% der intermetallischen Verbindung Nb₃Sn als A15 Phase sowie gegebenenfalls freies Nb und/oder Sn und unvermeidbare Verunreinigungen enthält.

Durch diese zusätzlichen Verfahrensschritt kann das bevorzugte Verfahrensprodukt, Nb₃Sn, in höherer Reinheit erhalten werden. Die Menge an unerwünschten Niobzinn-Verbindungen kann auf diese Weise weiter zurückgedrängt werden.

Gemäß dieser Ausführungsform wird der erste erhaltene Formkörper mechanisch zu Partikeln zerkleinert. Die zerkleinerten Partikel werden mit Nb- und/oder Sn-Partikeln möglichst homogen vermischt und zu einem zweiten Formkörper gepresst. Der Anteil der aus dem ersten Formkörper verwendeten Partikel sollte dabei höchstens 80 Gew.-% betragen. Das Material des ersten Formkörpers ist aufgrund des hohen Nb₃Sn-Anteils so spröde, dass ein Mindestanteil von 20 Gew.-% duktilen Materials benötigt wird, um einen mechanisch stabilen zweiten Formkörper zu erhalten. Dieser zweite Formkörper wird anschließend mit Hilfe eines Vakuum-Lichtbogen-Umschmelzverfahrens umgeschmolzen, wobei ein Dritter Formkörper erhalten wird.

Das Stoffmengenverhältnis von Nb zu Sn in Bezug auf das Endprodukt wird dabei so gewählt, dass der erhaltene dritte Formkörper wenigstens 70 Gew.-% der intermetallischen Verbindung Nb₃Sn als A15 Phase enthält. Ausgehend von dem ersten Formkörper wird somit so viel Nb oder Sn zur Herstellung des zweiten Formkörpers zugegeben, dass zu wenigstens 70 Gew.-% Nb₃Sn mit dem stöchiometrischen Verhältnis 3 Niob zu 1 Zinn entsteht und darüber hinaus im Wesentlichen freies Nb oder freies Sn im Produkt erhalten werden.

Bevorzugt wird das Stoffmengenverhältnis von Nb zu Sn so gewählt, dass der erhaltene Formkörper wenigstens 85 Gew.-%, weiter bevorzugt wenigstens 95 Gew.-%, weiter bevorzugt wenigstens 99 Gew.-%, weiter bevorzugt wenigstens 99,5 Gew.-%, und weiter bevorzugt wenigstens 99,9 Gew.-% der intermetallischen Verbindung Nb₃Sn als A15 Phase enthält.

Gegebenenfalls enthält der dritte Formkörper unvermeidbare Verunreinigungen.

Unvermeidbare Verunreinigungen sind insbesondere durch die Rohstoffe eingetragene Begleitelemente. Durch das zweite Umschmelzen im Lichtbogen unter Vakuum kann die Menge an solchen Verunreinigungen weiter verringert werden. Solche Verunreinigungen sind in Mengen kleiner als 0,05 Gew.-% im Verfahrens-Produkt nach dem zweiten Umschmelzen enthalten, bevorzugt in Mengen kleiner 50 mg/kg, jeweils bezogen auf die Gesamtmenge der Verunreinigung im Verfahrensprodukt.

Unvermeidbare Verunreinigungen sind ferner Niobzinn-Verbindungen die nicht in der A15 Phase, das heißt als Nb₃Sn, vorliegen. Insbesondere handelt es sich dabei um Nb₆Sn₅ sowie um NbSn₂. Bevorzugt ist jede dieser Verbindungen individuell für sich in einer Menge kleiner 1 Gew.-% nach dem zweiten Umschmelzen im Verfahrens-Produkt enthalten, weiter bevorzugt in einer Menge kleiner als 0,5 Gew-%, und weiter bevorzugt in einer Menge kleiner als 0,05 Gew.-%.

Der Vorteil eines zweiten Umschmelzens liegt ferner darin, dass der zweite Formkörper bereits einen signifikanten Anteil Nb₃Sn aufweist, welches einen niedrigeren Schmelzpunkt (2150 °C) als reines Niob (2477 °C) aufweist. Der hohe Dampfdruck des Zinns wirkt sich bei einer niedrigeren Arbeitstemperatur der Schmelze weniger problematisch aus, da ein unkontrolliertes Abdampfen des Zinns weniger stark zum tragen kommt.

In einer bevorzugten Ausführungsform der Erfindung werden die Sn-Partikel gemäß Schritt ii. sukzessive in die sich bildende Nb-Schmelze eingebracht.

Sukzessiver Eintrag bedeutet, dass die Sn-Partikel nicht in einem Schritt, sondern in kleinen Portionen über einen längeren zeitlichen Verlauf in die sich bildenden Nb-Schmelze eingetragen werden. Durch diesen sukzessiven Eintrag der Sn-Partikel in die sich bildende Nb-Schmelze werden Sn Abdampfverluste minimiert, wodurch die stöchiometrische Kontrolle der Reaktion verbessert und dadurch bevorzugt Nb₃Sn in der A15 Phase gebildet werden.

In einer bevorzugten Ausführungsform der Erfindung weisen die aus dem ersten Formkörper erhaltenen Partikel eine mittlere Querschnittsfläche auf, die höchstens ein Viertel der Querschnittsfläche des zweiten Formkörpers beträgt. Bevorzugt beträgt die mittlere Querschnittsfläche der Partikel des ersten Formkörpers höchstens ein Zehntel der Querschnittsfläche des zweiten Formkörpers, weiter bevorzugt ein Hundertstel, und weiter bevorzugt ein Tausendstel der Querschnittsfläche des zweiten Formkörpers.

Um die Verarbeitbarkeit der Partikel zum zweiten Formkörper zu erleichtern, muss der erste Formkörper mechanisch derart zerkleinert werden, dass die Mischbarkeit der aus dem ersten Formkörper erhaltenen Partikel mit zusätzlichen Nb und/oder Sn-Partikeln gewährleistet ist, so dass ein mechanisch stabiler zweiter Formkörper erhalten wird. Der zweite Formkörper ist dabei umso stabiler, je kleiner die mittlere Querschnittsfläche der aus dem ersten Formkörper erhaltenen Partikel ist.

Eine weitere Ausführungsform des erfindungsgemäßen Verfahrens ist dadurch gekennzeichnet, dass der Anteil der Sn-Partikeln an der Gesamtmenge vor dem Umschmelzen zum ersten Formkörper bei 30,0 Gew.-% bis 33,0 Gew.-% liegt.

Entsprechend wird ein Nb-Anteil von 67,0 bis 70,0 Gew.-% eingesetzt, so dass sich beide Gewichtsanteile auf 100 Gew.-% ergänzen. Ein Anteil von 30,0 bis 33,0 Gew.-% Sn entspricht einem Anteil von 25,2 at.-% (Atom-Prozent) bis 27,8 at.-% Zinn. Ein Anteil von 67,0 bis 70,0 Gew.-% Nb entspricht einem Anteil von 72,1 at.-% bis 75,3 at.-% Niob. In reinem Nb₃Sn liegt Sn mit einem Anteil von 25 at.-% und Nb mit einem Anteil von 75 at.-% vor. Gemäß dieser Ausführungsform wird Sn somit leicht überstöchiometrisch verwendet. Dadurch werden Sn-Verluste bei der Herstellung des ersten Formkörpers ausgeglichen. Solche Verluste können aufgrund der stark unterschiedlichen Schmelzpunkte von Nb und Sn auftreten, beispielsweise durch Abdampfen von Zinn während des Umschmelzens der Startelektrode zum ersten Formkörper oder durch Abdampfen von Zinn während des Umschmelzens des zweiten Formkörpers zum dritten Formkörper.

Eine weitere Ausführungsform des erfindungsgemäßen Verfahrens ist daher dadurch gekennzeichnet, dass der Anteil an Sn im zweiten Formkörper vor dem Umschmelzen zum dritten Formkörper bei 30,0 Gew.-% bis 33,0 Gew.-% liegt.

Die Ausführungen hinsichtlich der Zusammensetzung der Startelektrode zur Herstellung des ersten Formkörpers gelten analog für den zweiten Formkörper, der zum dritten Formkörper umgeschmolzen wird. Die Menge an Zinn und/oder Niob, die zu den aus dem ersten Formkörper erhaltenen Partikeln zugegeben werden muss um einen Gewichtsanteil von 30,0 Gew.-% bis 33,0 Gew.-% Sn einzustellen kann beispielsweise durch Elementaranalyse einer repräsentativen Probe der Partikel des ersten Formkörpers ermittelt werden. Wenn diese Zusammensetzung bekannt ist, können entsprechend Sn- und/oder Nb-Partikel zugemischt werden, so dass das gewünschte Gewichtsverhältnis Nb zu Sn erhalten wird.

Eine weitere Ausführungsform des erfindungsgemäßen Verfahrens ist dadurch gekennzeichnet, dass das Vakuum beim Umschmelzen einen Partialdruck von nicht mehr als 500 mbar aufweist. Bevorzugt weist das Vakuum beim Umschmelzen einen Partialdruck von 100 bis 300 mbar auf, besonders bevorzugt einen Partialdruck von 180 bis 220 mbar und weiter bevorzugt einen Partialdruck von 200 mbar.

Dies gilt sowohl für das angelegte Vakuum beim Umschmelzen der Startelektrode zum ersten Formkörper sowie für das Vakuum beim Umschmelzen des zweiten Formkörpers zum dritten Formkörper. Es wurde gefunden, dass die Zinn-Abdampfrate durch Verwendung eines nur mäßigen Vakuums signifikant reduziert werden kann. Aufgrund der hohen Schmelztemperaturen von Nb (2477 °C) und Nb₃Sn (2150 °C) kann unkontrolliertes Abdampfen von Zinn (Schmelztemperatur 262 °C; Siedetemperatur 2620 °C) im Vakuum auftreten, jedoch durch Anlegen eines nur mäßigen Vakuums verhindert werden. Der verwendete Partialdruck wirkt dem hohen Dampfdruck des Zinns entgegen. Das Arbeiten mit relativ hohem Partialdruck während des Umschmelzens ist insbesondere dann von Vorteil, wenn mit einer überstöchiometrischen Menge Zinn gearbeitet wird.

Eine weitere Ausführungsform des erfindungsgemäßen Verfahrens ist dadurch gekennzeichnet, dass das das Umschmelzen im Lichtbogen unter Vakuum unter einem gegenüber Nb und Sn inerten Schutzgas durchgeführt wird.

Die Verwendung eines Schutzgases erfüllt insbesondere den Zweck, die Oxidation von Nb und Sn zu entsprechenden Oxiden, beispielsweise zu Zinn(II)-oxid, Zinn(IV)-oxid oder Niob(V)-oxid, zu verhindern. Die Bildung von Metalloxiden würde die magnetischen und elektrischen Eigenschaften von Nb₃Sn negativ beeinflussen. Weiterhin wären die gebildeten Oxide aus dem unmittelbaren Verfahrensprodukt schwierig abzutrennen.

Eine weitere Ausführungsform des erfindungsgemäßen Verfahrens ist dadurch gekennzeichnet, dass als Schutzgas ein Edelgas verwendet wird.

Insbesondere wird Helium als Schutzgas unter den Edelgasen bevorzugt. Es wurde überraschend gefunden, dass bei der Verwendung von Helium beim Umschmelzprozess im Lichtbogen unter (Teil-)Vakuum wenig bis kein Plasma gebildet wird, während die Verwendung von Argon zu erheblicher Plasma-Bildung führte. Die Bildung von Plasma kann während des Schmelzvorgangs zu lokalen unkontrollierten Überhitzungen in der Schmelze führen, was in einer weniger kontrollierten Bildung von Nb₃Sn resultiert, was wiederum die Bildung von unerwünschten Nebenprodukten begünstigen kann.

Eine weitere Ausführungsform des erfindungsgemäßen Verfahrens ist dadurch gekennzeichnet, dass das Stoffmengenverhältnis von Nb zu Sn so gewählt ist, dass der erste Formkörper und/oder der dritte Formkörper 1 bis 5 Gew.-% freies Sn enthält, wobei der Rest des Formkörpers im Wesentlichen Nb₃Sn als A15 Phase aufweist.

Die Bildung eines Verfahrensprodukts mit einem Anteil von 1 bis 5 Gew.-% freiem Sn ist dann vorteilhaft, wenn bei der Verarbeitung des Materials ein hoher Energieeintrag notwendig ist. Ein Beispiel für einen solchen Fall ist die Weiterverarbeitung des Verfahrensprodukts zu einem Pulver und Verwendung des Pulvers in einem additiven Herstellverfahren. In solchen Verfahren kommen hochenergetische Strahlen in Form von Laser- oder Elektronenstrahlen zum Einsatz. Durch den punktuell hohen Energieeintrag kann die intermetallische Verbindung Nb₃Sn teilweise zersetzt werden, wodurch kleine Mengen Sn durch Abdampfen verloren gehen können. Aus diesem Grund ist es in einer bevorzugten Ausführungsform der Erfindung von Vorteil, wenn das unmittelbare Verfahrensprodukt freie Mengen an Sn enthält. Dieses freie Sn wird aufgrund seines niedrigen Schmelzpunktes durch den Laser oder Elektronenstrahl bevorzugt verdampft, so dass geringere Mengen an Nb₃Sn zersetzt werden, was zu einer besseren Reinheit des durch additive Fertigung hergestellten Produkts führt.

Eine weitere Ausführungsform des erfindungsgemäßen Verfahrens ist dadurch gekennzeichnet, dass der erste und/oder dritte Formkörper beim Umschmelzen in ein Behältnis aufgenommen wird, welches auf seiner Innenseite mit einer elektrisch isolierenden Schicht versehen ist.

Durch diese Maßnahme werden seitliche Lichtbogenentladungen vermindert bzw. minimiert, insbesondere in dem Fall, dass bei der Bildung des ersten Formkörpers während des Umschmelzens Sn-Partikel in die sich bildende Nb-Schmelze eingebracht werden.

Dabei ist besonders bevorzugt, dass die elektrisch isolierende Schicht eine Metalloxidschicht ist. Beispiele für geeignete Metalloxide sind Titan(IV)-oxid und Niob(V)-oxid. Der die Schmelze aufnehmende wassergekühlte Kupfertiegel wird für diesen Zweck auf der Innenseite bevorzugt mit einem der vorgenannten Metalloxide beschichtet. Dafür eignet sich beispielsweise eine Titan(IV)-oxid Dispersion auf Wasserbasis.

Einen Beitrag zur Lösung wenigstens einer der vorgenannten Aufgaben wird bereitgestellt durch eine intermetallische Niobzinn-Verbindung, erhältlich durch ein Verfahren nach einer der vorgenannten Ausführungsformen. Die intermetallische Niobzinn-Verbindung enthält als Hauptkomponente Nb₃Sn, zumindest enthält die intermetallische Verbindung wenigstens 50 Gew.-% reines Nb₃Sn in der A15 Phase, wobei freies Nb und freies Sn sowie weitere unvermeidbare Verunreinigungen in der intermetallischen Verbindung vorhanden sein können.

Eine Ausführungsform der intermetallischen Niobzinn-Verbindung ist dadurch gekennzeichnet, dass der Anteil an A15-Phase wenigstens 95 Gew.-% beträgt. Bevorzugt enthält die intermetallische Niobzinn-Verbindung somit wenigstens 95 Gew.-% Nb₃Sn in der A15 Phase, bevorzugt wenigstens 99 Gew.-%, und weiter bevorzugt wenigstens 99,5 Gew.-%.

Eine Ausführungsform der intermetallischen Niobzinn-Verbindung ist dadurch gekennzeichnet, dass der Anteil an Nb₆Sn₅ in der Zusammensetzung nicht mehr als 1 Gew.-% beträgt, bevorzugt nicht mehr als 0,5 Gew.-% beträgt, und weiter bevorzugt nicht mehr als 0,1 Gew.-% beträgt.

Eine Ausführungsform der intermetallischen Niobzinn-Verbindung ist dadurch gekennzeichnet, dass der Anteil NbSn₂ in der Zusammensetzung nicht mehr als 1 Gew.-% beträgt, bevorzugt nicht mehr als 0,5 Gew.-% beträgt, und weiter bevorzugt nicht mehr als 0,1 Gew.-% beträgt.

### Vakuum-Lichtbogen-Umschmelzverfahren

Unter einem "Vakuum-Lichtbogen-Umschmelzverfahren" oder "Umschmelzen in einem Lichtbogen unter Vakuum", auch *"vacuum arc remelting" (VAR)* wird ein dem Fachmann bekanntes Verfahren zur kontrollierten Verfestigung von Metallen, Legierungen und intermetallischen Verbindungen verstanden. Im Laufe des Verfahrens wird eine mit rechteckigem Querschnitt geformte Abschmelzelektrode in einen wassergekühlten Kupferschmelztiegel eines Ofens umgeschmolzen. Die Abschmelzelektrode kann erfindungsgemäß die Startelektrode oder der zweite Formkörper sein. Der Ofen wird evakuiert und zwischen der Elektrode (Kathode) und sogenanntem Startermaterial auf dem Grund des Schmelztiegels (Anode), auch als "Bodenschutz" bezeichnet, wird ein Gleichstromlichtbogen gezündet. Im erfindungsgemäßen Verfahren werden Nb₃Sn Partikel als Bodenschutz verwendet. Der Lichtbogen erhitzt sowohl das Startermaterial auf dem Grund des Schmelztiegels als auch die Elektrodenspitze, wobei beides geschmolzen wird. Während die Elektrodenspitze abgeschmolzen wird, tropft schmelzflüssiges Material in den darunter angeordneten Schmelztiegel und bildet dort erfindungsgemäß den ersten oder dritten Formkörper. Das Verfahren erhält einen Pool flüssiger Schmelze aufrecht, der einen Übergangsbereich hin zu einem vollkommen verfestigten Gussblock bildet. Der Durchmesser des Schmelztiegels ist größer als der Durchmesser der Startelektrode oder des zweiten Formkörpers. Daher lässt sich die ständig schrumpfende Elektrode in Richtung der AnodenOberfläche abwärts bewegen, um einen konstanten mittleren Abstand zwischen der Elektrodenspitze und dem Anoden-Pool aufrecht zu erhalten. Die mittlere Entfernung von der Elektrodenspitze zu der aus flüssigem Metall bestehenden Pooloberfläche wird als "Elektrodenabstand" bezeichnet.

In dem Maße wie Kühlwasser Wärme von der Schmelztiegelwand abführt, verfestigt sich schmelzflüssiges Metall in Nähe der Wand. Eine feste Schicht von Material, das sich an der Schmelztiegelwand in Nachbarschaft der Pooloberfläche verfestigt, wird als "Rand" bezeichnet. In einem gewissen Abstand unterhalb der Schmelzpooloberfläche kommt es zu einer vollständigen Verfestigung von Material, wobei ein vollkommen dichter Gussblock aus intermetallischer Verbindung entsteht.

Während des VAR-Prozesses verdampfen flüchtige Verunreinigungen. Als flüchtig kann im Sinne des erfindungsgemäßen Verfahrens auch Sn gesehen werden, weswegen im vorliegenden Fall vorzugsweise nicht mit Vakuum, sondern Teilvakuum gearbeitet wird um dem hohen Dampfdruck des Zinns entgegenzuwirken. Die Dämpfe flüchtiger Elemente schlagen sich während des VAR Prozesses auf kalten Oberflächen, beispielsweise auf der Fläche einer Schmelztiegelwand unmittelbar oberhalb des Randes aus erstarrendem Material nieder.

### Vakuum

Unter dem Begriff "Vakuum" wird im Sinne der Erfindung allgemein das Arbeiten unter vermindertem Luftdruck verstanden. Bevorzugt wird darunter ein Druck von weniger als 500 mbar verstanden, weiter bevorzugt von weniger als 300 mbar, oder 200 mbar, oder 50 mbar, oder 10 mbar, oder weniger als 1 mbar.

### Stoffmengenverhältnis

Unter "Stoffmengenverhältnis" wird erfindungsgemäß insbesondere das im beschriebenen Verfahren eingesetzte Verhältnis von Nb zu Sn, jeweils in "mol" oder "Äquivalenten", verstanden. Wird beispielsweise ein Stoffmengenverhältnis Nb zu Sn von 3:1 mol eingesetzt, dann kann daraus theoretisch zu 100 Prozent ein mol der intermetallischen Verbindung Nb₃Sn gebildet werden. Wird mit einem Stoffmengenverhältnis Nb zu Sn von 4:1 gearbeitet, kann daraus theoretisch ein mol intermetallische Verbindung Nb₃Sn gebildet werden, wobei ein mol freies Nb im Gemisch verbleiben würde. Erfindungsgemäß wird das Stoffmengenverhältnis von Nb zu Sn so gewählt, dass eine definierte Mindestmenge reines Nb₃Sn, beispielsweise wenigstens 50 Gew.-% oder wenigstens 70 Gew.%, und als "Rest" im Wesentlichen freies Nb oder Sn sowie unvermeidbare Verunreinigungen in der Produktzusammensetzung vorhanden sind.

"Überstöchiometrisch" bedeutet in diesem Zusammenhang, dass eine größere Menge Nb oder Sn eingesetzt wird, die zur stöchiometrischen Bildung von Nb₃Sn erforderlich sind. Gemäß dem obigen Beispiel mit 4 mol Nb und 1 mol Sn wird Nb überstöchiometrisch verwendet, da zur Bildung von 1 mol Nb₃Sn bei Einsatz von 1 mol Sn nur 3 mol Nb erforderlich sind.

### Partikel

Unter "Partikeln" werden definitionsgemäß feste Teilchen verstanden, die in unterschiedlicher Form oder Gestalt vorliegen und zu einem Formkörper gepresst werden können, wobei der Formkörper eine signifikant größere mittlere Querschnittsfläche aufweist als ein einzelner Partikel. Beispiele für erfindungsgemäß verwendete Partikelformen sind sphärische Partikel, Granalien (Körner), Flakes und Späne.

### Zinn, Niob, Niobzinn, Nb₃Sn und intermetallische Verbindung

Unter "Sn" oder "Zinn" wird erfindungsgemäß das Element Zinn in metallischer Form verstanden. Unter "Nb" oder "Niob" wird erfindungsgemäß das Element Niob in metallischer Form verstanden.

"Niobzinn" wird als Oberbegriff für alle bekannten und stabilen intermetallischen Niobzinn-Verbindungen verstanden, unabhängig von ihrer stöchiometrischen Zusammensetzung und der Art des Kristallgitters.

Unter "Nb₃Sn" wird eine intermetallische Verbindung aus 3 Niob-Atomen und 1 Zinn-Atom verstanden, wobei diese intermetallische Verbindung im Wesentlichen kristallin in derA15 Phase vorliegt.

"Intermetallische Verbindung" kann erfindungsgemäß nicht nur eine intermetallische Verbindung mit definierter stöchiometrischer Zusammensetzung *per se* bedeuten. In der intermetallischen Verbindung können im Sinne der Erfindung auch freie Metalle, insbesondere freies Nb und/oder Sn, sowie Legierungsbestandteile und unvermeidbare Verunreinigungen enthalten sein. Bei der intermetallischen Verbindung kann es sich somit auch um eine Zusammensetzung handeln, die jedoch wenigstens eine intermetallische Verbindung als solche aufweist.

### Ausführungsbeispiele

Im Folgenden werden Ausführungsbeispiele der Erfindung anhand einer schematisch dargestellten Figur und zweier Diagramme erläutert, ohne dabei die Erfindung zu beschränken. Dabei zeigt
- Figur 1: eine schematische Darstellung einer ersten Alternative des erfindungsgemäßen Verfahrens als Flussdiagramm;
- Figur 2: eine schematische Darstellung einer zweiten Alternative des erfindungsgemäßen Verfahrens als Flussdiagramm;
- Figur 3: eine Röntgendiffraktometrie Analyse des verfahrensgemäßen Produktes gemäß einem Ansatz mit stöchiometrischer Zusammensetzung;
- Figur 4: eine Röntgendiffraktometrie Analyse des verfahrensgemäßen Produktes gemäß einem Ansatz mit Zinn-Überschuss.

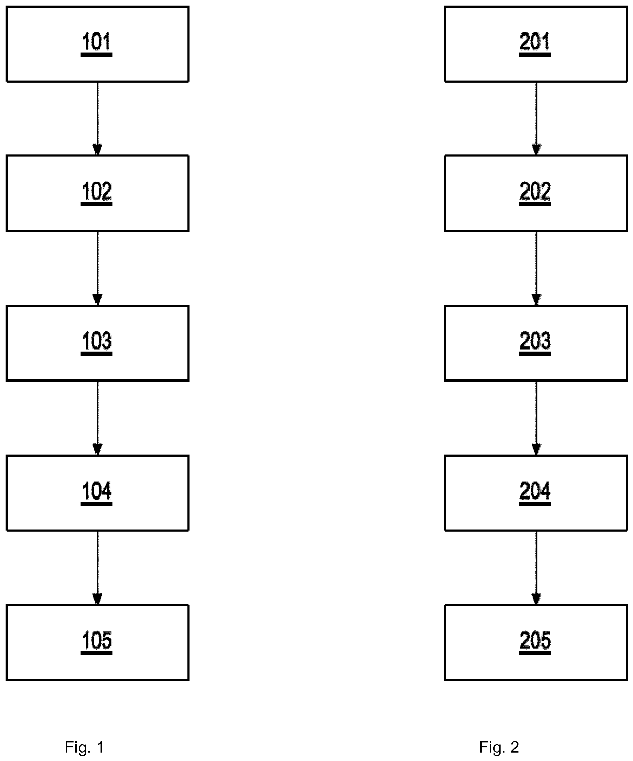

Figur 1 zeigt eine schematische Darstellung einer ersten Alternative des erfindungsgemäßen Verfahrens als Flussdiagramm. In einem ersten Schritt 101 werden zunächst Nb- und Sn-Partikel zu einer Startelektrode gepresst. Dabei können beispielsweise Nb Späne und Zinn Granalien (Metallkörner) verwendet werden. Die Startelektrode wird in einem folgenden Schritt 102 im Lichtbogen unter Vakuum als verzehrende Elektrode umgeschmolzen, wobei als erstes Produkt nach dem Abkühlen der Schmelze ein erster Formkörper erhalten wird. Dieser erste Formkörper weist bereits Nb₃Sn als Hauptphase (A15-Phase) auf. Zur weiteren Verbesserung der Reinheit des Produkts kann der erste Formkörper in einem weiteren Verfahrensschritt 103 mechanisch zu Partikeln zerkleinert werden. Die erhaltenen Partikel aus Nb₃Sn werden anschließend in einem Schritt 104 mit Nb- und Sn-Partikeln gemischt und zu einem zweiten Formkörper gepresst. Die so erhaltenen Nb₃Sn Partikel werden ein weiteres mal im Lichtbogen unter Vakuum in einem Schritt 105 umgeschmolzen, wobei ein dritter Formkörper aus Nb₃Sn erhalten wird.

Figur 2 zeigt eine schematische Darstellung einer zweiten Alternative des erfindungsgemäßen Verfahrens als Flussdiagramm. In einem ersten Schritt 201 wird ein Ingot aus Nb als Schmelzelektrode bereitgestellt. Die Elektrode wird in einem folgenden Schritt 202 im Lichtbogen unter Vakuum umgeschmolzen, wobei während dieses Umschmelzvorgangs Sn Partikel in die sich bildende Schmelze eingerieselt werden. Zum Einrieseln können beispielsweise Sn Granalien (Metallkörner) verwendet werden. Das Umschmelzprodukt, der erste Formkörper, weist bereits Nb₃Sn als Hauptphase (A15-Phase) auf. Zur weiteren Verbesserung der Reinheit des Produkts kann der erste Formkörper in einem weiteren Verfahrensschritt 203 mechanisch zu Partikeln zerkleinert werden. Die erhaltenen Partikel aus Nb₃Sn werden anschließend in einem Schritt 204 mit Nb- und Sn-Partikeln gemischt und zu einem zweiten Formkörper gepresst. Die so erhaltenen Nb₃Sn Partikel werden ein weiteres mal im Lichtbogen unter Vakuum in einem Schritt 205 umgeschmolzen, wobei ein dritter Formkörper aus Nb₃Sn erhalten wird.

### Beispiel 1

Im folgenden wird die Herstellung gemäß der ersten Alternative des erfindungsgemäßen Verfahrens unter Verwendung eines einzigen Umschmelzvorgangs anhand eines konkreten Ausführungsbeispiels erläutert.

Aus Nb Spänen und Sn Granalien wurde zunächst eine Presselektrode der Abmessung 35 x 32 x 480 mm in einem Rechteckgesenk mit einer Presskraft von 500 t hergestellt. Die so erhaltene Elektrode wies ein Gewicht von 3,74 kg auf. Für das Vakuum-Lichtbogen-Umschmelzverfahren wurde als Bodenschutz eine Menge von 100 g Nb₃Sn Partikel eingesetzt. Die Elektrode wurde im Lichtbogenofen als verzehrende Elektrode in einen wassergekühlten Kupfertiegel mit einem Innendurchmesser von 80 mm umgeschmolzen. Um die Abdampfung von Sn zu minimieren wurde dabei mit einem Partialdruck von 200 mbar gearbeitet. Der Kupfertiegel wurde innenisoliert, um seitliche Lichtbogenentladungen zu verhindern. Als Partialdruckgas wurde Argon verwendet. Während der Schmelze, bei der die Schmelzleistung 70 kW betrug (2,0 kA / 35 V), kam es zu einer leichten Plasmabildung. Der erschmolzene Block, d.h. der erste Formkörper, wies ein Gewicht von 3,79 kg auf. Der Sn Gesamtverlust betrug somit 50 g.

In einem verbesserten Ansatz wurde anstatt mit Argon mit Helium als Partialdruckgas gearbeitet. In diesem Ansatz wurde eine Presselektrode aus Nb und Sn mit einem Gesamtgewicht von 3,77 kg eingesetzt. Dabei wurde ein erster Formkörper mit einem Gesamtgewicht von 3,80 kg erhalten. Der Sn Verlust betrug 70 g. Durch die Verwendung von Helium als Partialdruckgas konnte Plasmabildung vermieden werden, d.h. es wurde keine Plasmabildung während des Umschmelzvorgangs beobachtet.

### Beispiel 2

Im folgenden wird die Herstellung gemäß der zweiten Alternative des erfindungsgemäßen Verfahrens unter Verwendung eines einzigen Umschmelzvorgangs anhand eines konkreten Ausführungsbeispiels erläutert.

Ein Niob Walzprofil-Stab mit einer Schlüsselweite von 32 mm und einer Länge von 480 mm wurde als verzehrende Elektrode im Lichtbogenofen umgeschmolzen. Die Niob-Elektrode wies ein Gewicht von 3,57 kg auf. Als Bodenschutz wurden 100 g Nb₃Sn verwendet. Um die intermetallische Zusammensetzung Nb₃Sn während der Schmelze zu erzeugen wurden halbkontinuierlich 1,64 kg Zinn Granalien (Metallkörner) in die Schmelz eingerieselt. Jeweils nach 20 mm Verfahrensweg der Elektrode wurden 68,3 g Zinn Granalien über einen Drehtellerförderer in die Niob-Schmelze gegeben. Während des Schmelz- und Einriesel-Vorgangs wurde mit einem Partialdruck von 200 mbar gearbeitet, wobei Helium als Partialdruckgas verwendet wurde. Die Verwendung von 200 mbar Partialdruck und Helium dienten wiederum der Minimierung von sowohl des Abdampfens von Sn als auch der Bildung von Plasma. Um seitliche Lichtbogenentladungen zu verhindern wurde ein innenisolierter Kupfertiegel verwendet und mit einem konstant drehenden Rührfeld gearbeitet. Die Schmelzleistung betrug 70 kW (2,0 kA / 35 V). Der erschmolzene Block oder erste Formkörper wies ein Gewicht von 5,14 kg auf. Der Sn Verlust betrug 70 g.

### Beispiel 3

Im Folgenden wird die Weiterverarbeitung des nach der ersten Alternative (Beispiel 1) oder zweiten Alternative (Beispiel 2) des erfindungsgemäßen Verfahrens hergestellten Formkörpers unter Verwendung eines zweiten Umschmelzvorgangs näher erläutert.

Der nach einem der obigen Ansätze erhaltene erste Formkörper war extrem spröde und konnte dadurch einfach mechanisch gebrochen werden. Entsprechend wurden aus dem ersten Formkörper Partikel mit einer maximalen Ausdehnung von 5 mm in einem Backenbrecher hergestellt. Zur Homogenisierung wurden die Partikel händisch in einem Metallfass gemischt, die zu einem zweiten Formkörper gepresst werden konnten.

Zum Erschmelzen von hochreinem Nb₃Sn in A15 Phase wurde anschließend eine Presselektrode, d.h. der zweite Formkörper, mit einer Abmessung D x 35 x 480 mm (D = variable Dicke) mit einer Presskraft von 500 t hergestellt. Das Gewicht der Presselektrode betrug 5000 g.

Je nachdem ob mit einer stöchiometrischen oder überstöchiometrischen (Sn Überschuss) Zusammensetzung gearbeitet wurde, hatte die Presselektrode oder der zweite Formkörper die folgende Zusammensetzung:

| **Ansatz Nr.** | **Verhältnis Nb:Sn** | **Anteil Partikel aus erstem Formkörper (Gew.-%)** | **Anteil Nb Späne (Gew.-%)** | **Anteil Sn Granalien (Gew.-%)** |
|---|---|---|---|---|
| 1 | stöchiometrisch | 50 | 35 | 15 |
| 2 | Sn Überschuss | 50 | 33 | 17 |

Die Presselektroden oder zweite Formkörper nach Ansatz Nr. 1 oder 2 wurden jeweils im Lichtbogenofen als verzehrende Elektrode erschmolzen. Während des Schmelzvorgangs wurde mit einem Partialdruck von 200 mbar gearbeitet, was auch hier der Minimierung des Abdampfens von Sn diente. Als Partialdruckgas wurde Helium verwendet, um wiederum Plasmabildung zu unterbinden. Um seitliche Lichtbogenentladungen zu verhindern wurde ein innenisolierter Kupfertiegel verwendet. Zur weiteren Minimierung von seitlichen Lichtbogenentladungen wurde ferner ein konstant drehendes Rührfeld verwendet. Die Schmelzleistung betrug 70 kW (2,0 kA / 35 V).

Der erschmolzene Block oder dritte Formkörper nach Ansatz 1 wies ein Gewicht von 4,91 kg auf. Der Gewichtsverlust an Zinn betrug 90 g.

Der erschmolzene Block oder dritte Formkörper nach Ansatz 2 wies ein Gewicht von 4,93 kg. Der Gewichtsverlust an Zinn betrug 87 g.

Zur Vorbereitung der folgenden Analysen wurden Bruchstücke des erhaltenen Formkörpers zufällig entnommen. Zur Röntgendiffraktometrie-Analyse wurde ein Bruchstück an einer Stelle plan bearbeitet. Zur chemischen Analyse wurde das ausgewählte Bruchstück mechanisch zerkleinert.

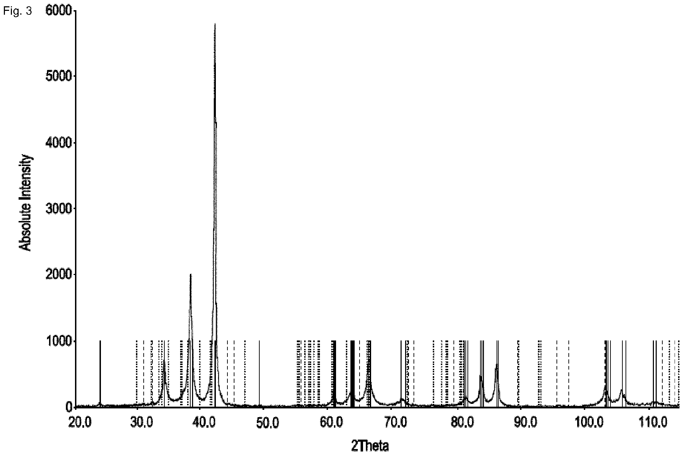

Figur 3 zeigt eine Röntgendiffraktometrie-Analyse (*X-ray diffraction - XRD*) des Blocks oder dritten Formkörpers nach Ansatz 1. Die senkrechten Striche entlang der x-Achse zeigen Referenzsignale, das heißt die zu erwartenden Positionen der Signale für Nb₃Sn in A15 Phase (durchgehende Linien), NbSn₂ (gepunktete Linien) oder freies Sn (gestrichelte Linien). Die Signalstärke der einzelnen Komponenten der Probe kommt durch die an den jeweiligen Referenzpositionen ausgegebenen Peaks zum Ausdruck. Hierbei ist zu erkennen, dass die Probe nach Ansatz 1 Im Wesentlichen Peaks im Bereich der durchgehenden Referenzlinien, das heißt Peaks aufweist die Nb₃Sn in A15 Phase zuzuordnen sind. Peaks für NbSn₂ und freies Sn sind nur sehr schwach ausgeprägt beziehungsweise sind im Rauschen der einzelnen Signale kaum erkennbar.

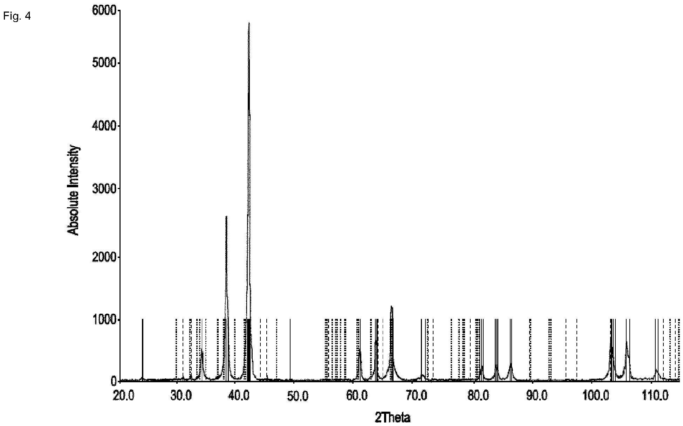

Figur 4 zeigt eine Röntgendiffraktometrie-Analyse (*X-ray diffraction - XRD*) des Blocks oder dritten Formkörpers nach Ansatz 2, in dem mit einem Sn Überschuss gearbeitet wurde. Auch in diesem Fall dominieren die Signale beziehungsweise peaks von Nb₃Sn in A15 Phase, während reinem Sn und NbSn₂ zuzuordnende Peaks nur schwach ausgeprägt sind.

Die Röntgendiffraktometrie Analysen erbringen insofern den Nachweis, dass sich das erfindungsgemäße Verfahren zur Darstellung von reinem Nb₃Sn in A15 Phase eignet.

Die folgende Tabelle zeigt die Zusammensetzung der erhaltenen Produkte nach Beispiel 1 und Beispiel 3 gemäß einer chemischen Analyse. Für Beispiel 3 sind die beiden Proben nach Ansatz 1 und Ansatz 2 aufgezeigt.

| **Beispiel Nr.** | **Nb (Gew.-%)** | **Sn (Gew.-%)** |
|---|---|---|
| Beispiel 1 | 71,1 | 28,8 |
| Beispiel 3, Ansatz 1 (stöchiometrisch) | 70,6 | 29,3 |
| Beispiel 3, Ansatz 2 (Sn Überschuss) | 69,0 | 30,9 |

Reines Nb₃Sn weist im Idealfall einen Nb Gehalt von 70,1 Gew.-% und einen Sn Gehalt von 29,9 Gew.-% auf.

## Patentansprüche

1. Verfahren zur schmelzmetallurgischen Darstellung der intermetallischen Verbindung Nb₃Sn, wobei das Verfahren die folgenden Schritte umfasst:
i. Pressen von Nb-Partikeln und Sn-Partikeln zu einer Startelektrode (101), wobei die gepresste Startelektrode in einem Lichtbogen unter Vakuum umgeschmolzen wird (102), wobei ein erster Formkörper erhalten wird oder
ii. Umschmelzen einer Nb-Startelektrode in einem Lichtbogen unter Vakuum (201), wobei während des Umschmelzens Sn-Partikel in die sich bildende Nb-Schmelze eingebracht werden (202), wobei ein erster Formkörper erhalten wird,
wobei das Stoffmengenverhältnis von Nb zu Sn so gewählt ist, dass der erhaltene erste Formkörper wenigstens 50 Gew.-% der intermetallischen Verbindung Nb₃Sn als A15 Phase sowie gegebenenfalls freies Nb und/oder Sn und unvermeidbare Verunreinigungen enthält.

2. Verfahren nach Anspruch 1, wobei das Verfahren zusätzlich die folgenden Verfahrensschritte umfasst:
a. Mechanisches Zerkleinern des ersten Formkörpers zu Partikeln (103, 203),
b. Mischen der in Schritt a. erhaltenen Partikeln mit Nb- und/oder Sn-Partikeln und Pressen der Mischung zu einem zweiten Formkörper (104, 204), wobei der Anteil der in Schritt a. erhaltenen Partikel im zweiten Formkörper bei höchstens 80 Gew.-% liegt,
c. Umschmelzen des zweiten Formkörpers in einem Lichtbogen unter Vakuum (105, 205), wobei ein dritter Formkörper erhalten wird,
wobei das Stoffmengenverhältnis von Nb zu Sn so gewählt ist, dass der erhaltene dritte Formkörper wenigstens 70 Gew.-% der intermetallischen Verbindung Nb₃Sn als A15 Phase sowie gegebenenfalls freies Nb und/oder Sn und unvermeidbare Verunreinigungen enthält.

3. Verfahren nach Anspruch 1 oder 2, **dadurch gekennzeichnet, dass** gemäß Schritt ii. die Sn-Partikel sukzessive in die sich bildende Nb-Schmelze eingebracht werden.

4. Verfahren nach Anspruch 2 oder 3, **dadurch gekennzeichnet, dass** die aus dem ersten Formkörper erhaltenen Partikel eine mittlere Querschnittsfläche aufweisen, die höchstens ein Viertel der Querschnittsfläche des zweiten Formkörpers beträgt.

5. Verfahren nach einem der vorhergehenden Ansprüche, **dadurch gekennzeichnet, dass** der Anteil der Sn-Partikeln an der Gesamtmenge vor dem Umschmelzen zum ersten Formkörper bei 30,0 Gew.-% bis 33,0 Gew.-% liegt.

6. Verfahren nach einem der vorhergehenden Ansprüche, **dadurch gekennzeichnet, dass** der Anteil an Sn im zweiten Formkörper vor dem Umschmelzen zum dritten Formkörper bei 30,0 Gew.-% bis 33,0 Gew.-% liegt.

7. Verfahren nach einem der vorangehenden Ansprüche, **dadurch gekennzeichnet, dass** das Vakuum beim Umschmelzen einen Partialdruck von nicht mehr als 500 mbar aufweist.

8. Verfahren nach einem der vorangehenden Ansprüche, **dadurch gekennzeichnet, dass** das Umschmelzen im Lichtbogen unter Vakuum unter einem gegenüber Nb und Sn inerten Schutzgas durchgeführt wird.

9. Verfahren nach Anspruch 8, **dadurch gekennzeichnet, dass** als Schutzgas ein Edelgas verwendet wird.

10. Verfahren nach Anspruch 9, **dadurch gekennzeichnet, dass** als Schutzgas Helium verwendet wird.

11. Verfahren nach einem der vorangehenden Ansprüche, **dadurch gekennzeichnet, dass** das Stoffmengenverhältnis von Nb zu Sn so gewählt ist, dass der erste Formkörper und/oder der dritte Formkörper 1 bis 5 Gew.-% freies Sn enthält, wobei der Rest des Formkörpers im Wesentlichen Nb₃Sn als A15 Phase aufweist.

12. Verfahren nach einem der vorangehenden Ansprüche, **dadurch gekennzeichnet, dass** der erste und/oder dritte Formkörper beim Umschmelzen in ein Behältnis aufgenommen wird, welches auf seiner Innenseite mit einer elektrisch isolierenden Schicht versehen ist.

13. Verfahren nach Anspruch 12, **dadurch gekennzeichnet, dass** die elektrisch isolierende Schicht eine Metalloxidschicht ist.

14. Intermetallische Niobzinn-Verbindung, erhältlich durch ein Verfahren nach einem der Ansprüche 1 bis 13.

15. Intermetallische Niobzinn-Verbindung nach Anspruch 14, **dadurch gekennzeichnet, dass** der Anteil an A15-Phase wenigstens 95 Gew.-% beträgt.

16. Intermetallische Niobzinn-Verbindung nach einem der Ansprüche 14 oder 15, **dadurch gekennzeichnet, dass** der Anteil an Nb₆Sn₅ in der Zusammensetzung nicht mehr als 1 Gew.-% beträgt.

17. Intermetallische Niobzinn-Verbindung nach einem der Ansprüche 14 bis 16, **dadurch gekennzeichnet, dass** der Anteil NbSn₂ in der Zusammensetzung nicht mehr als 1 Gew.-% beträgt.
